# EUROPEAN PATENT SPECIFICATION

(11) **EP 4 167 273 B1**
(45) Date of publication and mention of the grant of the patent: **08.10.2025**
(21) Application number: 22737361.0
(22) Date of filing: 24.02.2022
(51) Int. Cl.: H10B 12/00, H10D 30/01, H10D 30/67

(54) **SEMICONDUCTOR STRUCTURE AND METHOD FOR FORMING SAME**
HALBLEITERSTRUKTUR UND VERFAHREN ZU IHRER HERSTELLUNG
STRUCTURE SEMI-CONDUCTRICE ET SON PROCÉDÉ DE FORMATION

(30) Priority: 30.08.2021 CN 202111007272
(43) Date of publication of application: 19.04.2023
(73) Proprietor: Changxin Memory Technologies, Inc., Hefei City, Anhui 230601 (CN); Beijing Superstring Academy of Memory Technology, Beijing 100176 (CN)
(72) Inventor: SHAO, Guangsu, Hefei Anhui 230601 (CN); XIAO, Deyuan, Hefei Anhui 230601 (CN); HAN, Qinghua, Hefei Anhui 230601 (CN); QIU, Yunsong, Hefei Anhui 230601 (CN); BAI, Weiping, Hefei Anhui 230601 (CN)
(74) Representative: Lavoix
(86) International application number: PCT/CN2022/077721
(87) International publication number: WO 2023/029399

(56) References cited:
- CN-A- 105 206 670
- CN-A- 106 298 778
- CN-A- 109 841 675
- CN-A- 111 211 170
- US-A1- 2011 079 823
- US-A1- 2014 061 778
- US-A1- 2015 349 059
- US-A1- 2017 330 958
- US-A1- 2018 374 855
- US-A1- 2020 066 599
- US-B1- 9 786 784

## Description

### CROSS-REFERENCE TO RELATED APPLICATION

This application is based on and claims priority to Chinese Patent Application No. 202111007272.0, filed on August 30, 2021 and entitled "SEMICONDUCTOR STRUCTURE AND METHOD FOR FORMING SEMICONDUCTOR STRUCTURE'.

### TECHNICAL FIELD

The application relates to the technical field of semiconductors, and relates, but is not limited, to a semiconductor structure and a method for forming a semiconductor structure.

### BACKGROUND

Since a Gate All Around Field Effect Transistor, GAAFET, has better characteristics for controlling a gate, it can achieve better switching characteristics and more effective suppression of short-channel effects, and thus it is considered to be the best candidate as the replacement of the traditional field effect transistors. However, a process for preparing a GAAFET channel is complicated, and random fluctuation of the process is obvious due to the small dimension. Therefore, it is necessary to pay a special attention to the influence of the process fluctuation on the electrical performances of devices and circuits.

US2018/374855A1 discloses an apparatus having a transistor associated with a vertically-extending semiconductor pillar. The transistor includes an upper source/drain region within the vertically-extending semiconductor pillar, a lower source/drain region within the vertically-extending semiconductor pillar, and a channel region within the vertically-extending semiconductor pillar and between the upper and lower source/drain regions. The transistor also includes a gate along the channel region. A wordline is coupled with the gate of the transistor. A digit line is coupled with the lower source/drain region of the transistor. A programmable device is coupled with the upper source/drain region of the transistor. A body connection line is over the wordline and extends parallel to the wordline. The body connection line has a lateral edge that penetrates into the vertically-extending semiconductor material pillar. The body connection line is of a different composition than the semiconductor material pillar.

US2011/079823A1 discloses a vertical transistor includes a substrate, a gate, a source region, a drain region, a channel region and a gate dielectric layer. A trench is formed in the substrate, and the gate is disposed in the trench. The source region is disposed in the substrate beneath the gate. The drain region is disposed above the gate. The channel region is disposed at two sides of the gate and located between the source region and the drain region. The gate dielectric layer is located between the gate and the channel region.

US2014/061778A1 discloses a semiconductor device includes semiconductor bodies formed substantially perpendicular to a semiconductor substrate, buried bit lines formed in the semiconductor bodies and including a metal silicide; and barrier layers formed under and over the buried bit lines and containing germanium.

US2017/330958A1 discloses a process for fabricating a vertical transistor , including steps of providing a substrate surmounted by a stack of first to third layers made of first to third semiconductors materials of two different types; partially etching the first and third layers with an etching that is selective, so as to form a first void in the first layer and a third void in the third layer, extending to the lower surface and to the upper surface of the second layer, respectively; filling the voids in order to form spacers making contact with the lower surface and the upper surface, respectively; partially etching the second layer with an etching that is selective, so as to form a second void between the first and second spacers; and depositing a conductor material in the second void.

### SUMMARY

According to a first aspect there is provided a method for manufacturing the semiconductor structure and a semiconductor structure as set out in the independent claims. Embodiments may comprise features as set out in dependent claims.

### BRIEF DESCRIPTION OF THE DRAWINGS

In the accompanying drawings (which are not necessarily drawn to scale), similar reference numerals may denote similar components in different diagrams. The similar reference numerals having different letter suffixes may denote different examples of the similar components. The accompanying drawings generally illustrate various embodiments discussed in the application by way of example and not by way of limitation.
FIG. 1A is a flowchart of a method for forming a semiconductor structure according to an embodiment of the application;
FIG. 1B to FIG. 1E are schematic diagrams of a forming process of a semiconductor structure according to an embodiment of the application;
FIG. 2A is another flowchart of a method for forming a semiconductor structure according to an embodiment of the application;
FIG. 2B to FIG. 2K are other schematic diagrams of a forming process of a semiconductor structure according to an embodiment of the application;
FIG. 3A is a schematic diagram of a semiconductor structure according to an embodiment of the application;
FIG. 3B is a front view of the structure shown in FIG. 3A;
FIG. 4A is another flowchart of a method for forming a semiconductor structure according to an embodiment of the application; and
FIG. 4B to FIG. 4E are other schematic diagrams of a forming process of a semiconductor structure according to an embodiment of the application.

### DETAILED DESCRIPTION

Exemplary embodiments of the application will be described in more detail below with reference to the accompanying drawings. Although the exemplary embodiments of the application are shown in the accompanying drawings, it should be understood that the application can be implemented in various forms and cannot be limited by specific embodiments illustrated herein. On the contrary, these embodiments are provided to more thoroughly understand the application and to completely convey the scope of the application to those skilled in the art.

In the following description, numerous specific details are set forth in order to provide a more thorough understanding of the application. However, it will be apparent for those skilled in the art that the application can be implemented without one or more of these details. In other examples, in order to avoid confusion with the application, some technical features known in the art are not described. That is, all the features of the actual embodiments are not described here, and the well-known functions and structures are not described in detail.

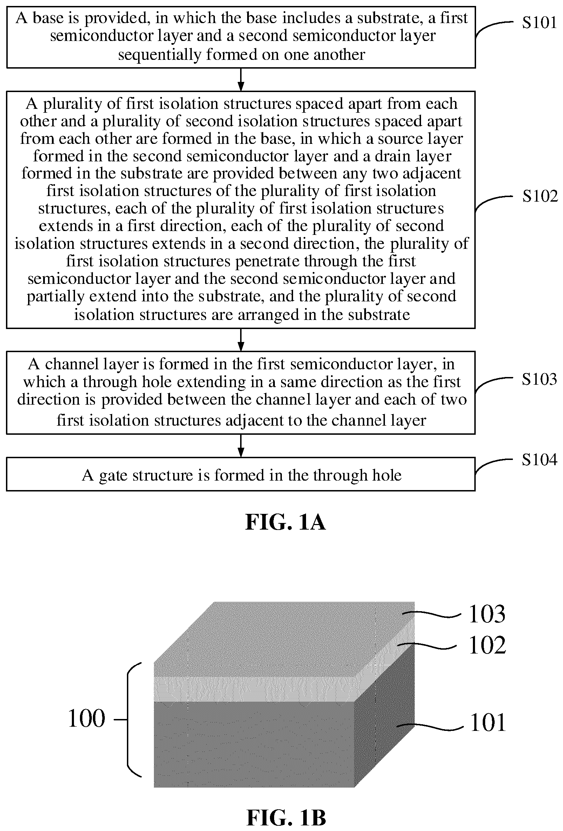

An embodiment of the application provides a method for forming a semiconductor structure. As shown in FIG. 1A, the method includes the following operations.

In S101, a base is provided, in which the base includes a substrate, a first semiconductor layer and a second semiconductor layer sequentially formed on one another.

The substrate may be a silicon substrate, a silicon germanium substrate, or a Silicon On Insulator, SOI, substrate, and may also be a silicon nitride substrate or other suitable substrates.

A material of the first semiconductor layer may be silicon (Si), germanium (Ge), or silicon germanium (SiGe), silicon carbide (SiC); and may also be Silicon On Insulator, SOI, or Germanium on Insulator, GOI; or may also be other materials, for example, III-V group compounds such as gallium arsenide. In terms of a Complementary Metal Oxide Semiconductor, CMOS, process, the cost of a silicon germanium process is comparable to the cost of a silicon process. However, in terms of the heterojunction technology, the cost of the silicon germanium process is lower than the cost of a gallium arsenide process.

The second semiconductor layer may be a silicon layer, and may also include other semiconductor elements such as germanium (Ge); or includes semiconductor compounds such as silicon carbide (SiC), gallium arsenide (GaAs), gallium phosphide (GaP), indium phosphide (InP), indium arsenide (InAs), or indium antimonide (InSb); or includes other semiconductor alloys such as silicon germanium (SiGe), gallium arsenide phosphide (GaAsP), indium aluminum arsenide (AlInAs), gallium aluminum arsenide (AlGaAs), indium gallium arsenide (GaInAs), indium gallium phosphide (GaInP), and/or indium gallium arsenide phosphide (GaInAsP) or a combination thereof.

In some embodiments, the first semiconductor layer and the second semiconductor layer may be formed through epitaxy. An epitaxial growth method may adopt Molecular Beam Epitaxy, MBE, a combination of ultralow pressure chemical vapor deposition and ultrahigh vacuum technology (Ultrahigh Vacuum Chemical Vapor Deposition, UHV/CVD), Ultra Violet Chemical Vapor Deposition, UV/CVD, Atmospheric Pressure Chemical Vapor Deposition, APCVD, and Rapid Thermal Chemical Vapor Deposition, RT-CVD, or the like. These technologies have the advantage that they can grow an epitaxial layer at a low temperature (from 300 degrees Celsius, °C, to 700 °C). This capability is not only important for the generation of the doped planes, but also allows the lattice-mismatched materials to be combined with each other in a coherent manner. In the silicon germanium alloy, since the carriers in the quantum well composed of silicon (Si) and silicon germanium have a higher mobility, the mobility of electrons thereof is almost twice that of pure silicon. More importantly, when silicon and germanium are alloyed, the free-standing alloy has a diamond crystal lattice, and the lattice constant of the alloy is almost linearly dependent between silicon and germanium values, with a deviation of about 4.17% at room temperature. When such a silicon germanium layer is epitaxially grown on a substrate (such as a silicon substrate) with the same lattice constant, a growing layer attempts to modify its in-plane lattice constant, in order to form a coherent crystal plane with the substrate layer.

In S102, a plurality of first isolation structures spaced apart from each other and a plurality of second isolation structures spaced apart from each other are formed in the base, in which a source layer formed in the second semiconductor layer and a drain layer formed in the substrate are provided between any two adjacent first isolation structures of the plurality of the first isolation structures, each of the plurality of first isolation structures extends in a first direction, each of the plurality of second isolation structures extends in a second direction, the plurality of first isolation structures penetrate through the first semiconductor layer and the second semiconductor layer and partially extend into the substrate, and the plurality of second isolation structures are arranged in the substrate.

Herein, in a direction of a top surface and a bottom surface of the base (i.e., a plane on which the base is located), the two directions that intersect with each other (e.g., the two directions are perpendicular to each other) are the first direction and the second direction. For example, the first direction is defined as the X-axis direction, and the second direction is defined as the Y-axis direction. The drain layer and the source layer have opposite conductive types.

In S103, a channel layer is formed in the first semiconductor layer, in which a through hole extending in a same direction as the first direction is provided between the channel layer and each of two first isolation structures adjacent to the channel layer.

Herein, the channel layer is arranged between the drain layer and the source layer.

In S104, a gate structure is formed in the through hole.

Herein, the first isolation structure is configured to isolate the gate structures from each other. The gate structure may include a gate oxide layer and a conductive material on a surface of the gate oxide layer. The gate oxide layer may serve as a dielectric layer to realize electric isolation between the gate structure and the base. The gate oxide layer may be formed through high temperature oxidation, and the temperature for the high temperature oxidation process may be comprised between 900 °C and 1200 °C. A material of the gate oxide layer may be silicon oxide, silicon nitride, silicon oxynitride, Oxide/Nitride/Oxide, ONO, or a high-k material with a higher dielectric constant than that of the silicon oxide layer, so that it can effectively prevent boron from polysilicon from diffusing to solve the problem of boron penetration. Meanwhile, a small amount of nitrogen atoms distributed on the interface between the gate oxide layer and the base can also improve characteristics of the interface, thereby enhancing the reliability of the gate oxide layer, and reducing the leakage current. For example, the high-k material may have a dielectric constant comprised between about 10 and 25, and may include, for example, hafnium oxide (HfO₂), aluminum oxide (Al₂O₃), hafnium aluminum oxide (HfAlO₃), tantalum oxide (Ta₂O₃), and/or titanium oxide (TiO₂).

In the embodiment of the application, the plurality of first isolation structures and the plurality of second isolation structures are formed in the base, the channel layer is formed in the first semiconductor layer, and the gate structure is formed in the through hole of the channel layer, so that gate self-alignment is realized, and a gate all round structure is formed, thereby improving the gate control capability and the switching speed.

S101 to S104 are illustrated respectively with reference to FIG. 1B to FIG. 1E.

As shown in FIG. 1B, the base 100 includes a substrate 101, a first semiconductor layer 102, and a second semiconductor layer 103 which are sequentially formed on one another.

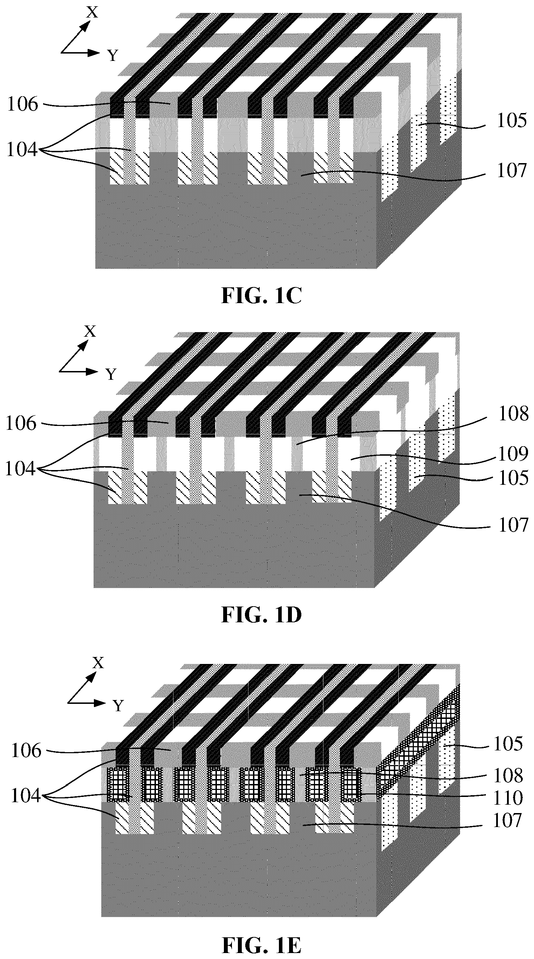

With reference to FIG. 1B and FIG. 1C, a plurality of first isolation structures 104 spaced apart from each other and a plurality of second isolation structures 105 spaced apart from each other are formed in the base (see the base 100 shown in FIG. 1B). A source layer 106 formed in the second semiconductor layer (see the second semiconductor layer 103 shown in FIG. 1B) and a drain layer 107 formed in the substrate (see the substrate 101 shown in FIG. 1B) are provided between any two adjacent first isolation structures 104. Each first isolation structure 104 extends in the X-axis direction, and each second isolation structure 105 extends in the Y-axis direction. The plurality of first isolation structures 104 penetrate through the first semiconductor layer (see the first semiconductor layer 102 shown in FIG. 1B) and the second semiconductor layer 103, and partially extend into the substrate 101. The plurality of second isolation structures 105 are arranged in the substrate 101.

As shown in FIG. 1D, a channel layer 108 is formed in the first semiconductor layer (see the first semiconductor layer 102 shown in FIG. 1B). A through hole 109 extending in a same direction as the first direction is provided between a sidewall of the channel layer 108 and each sidewall of two first isolation structures 104 adjacent to the channel layer along the second direction.

As shown in FIG. 1E, a gate structure 110 is formed in the through hole 109 (see the through hole 109 shown in FIG. 1D).

On the basis of a method for forming a semiconductor structure provided in FIG. 1A, an embodiment of the application provides a semiconductor structure. As shown in FIG. 1E, the semiconductor structure includes:
a base (see the base 100 shown in FIG. 1B), in which the base includes a substrate (see the substrate 101 shown in FIG. 1B), a first semiconductor layer (see the first semiconductor layer 102 shown in FIG. 1B), and a second semiconductor layer (see the second semiconductor layer 103 shown in FIG. 1B) which are sequentially formed on one another;
a plurality of first isolation structures 104 spaced apart from each other and a plurality of second isolation structures 105 spaced apart from each other in the base 100, in which each first isolation structure 104 extends in a first direction, each second isolation structure 105 extends in a second direction, the plurality of first isolation structures 104 penetrate through the first semiconductor layer 102 and the second semiconductor layer 103 and partially extend into the substrate 101, and the plurality of second isolation structures 105 are arranged in the substrate 101;
a source layer 106 arranged in the second semiconductor layer 103;
a drain layer 107 arranged in the substrate 101;
a channel layer 108 arranged in the first semiconductor layer 102; and
a gate structure 110 arranged between the sidewall of the channel layer 108 and each sidewall of two first isolation structures 104 adjacent to the channel layer and extending in a same direction as the first direction.

In some embodiments, the substrate is a silicon substrate, the first semiconductor layer is a silicon germanium layer, and the second semiconductor layer is a silicon layer. The carriers in the silicon germanium layer have a higher mobility, and the electron mobility thereof is twice that of the pure silicon layer.

In some embodiments, the gate structure includes a gate oxide layer, and a conductive material on a surface of the gate oxide layer.

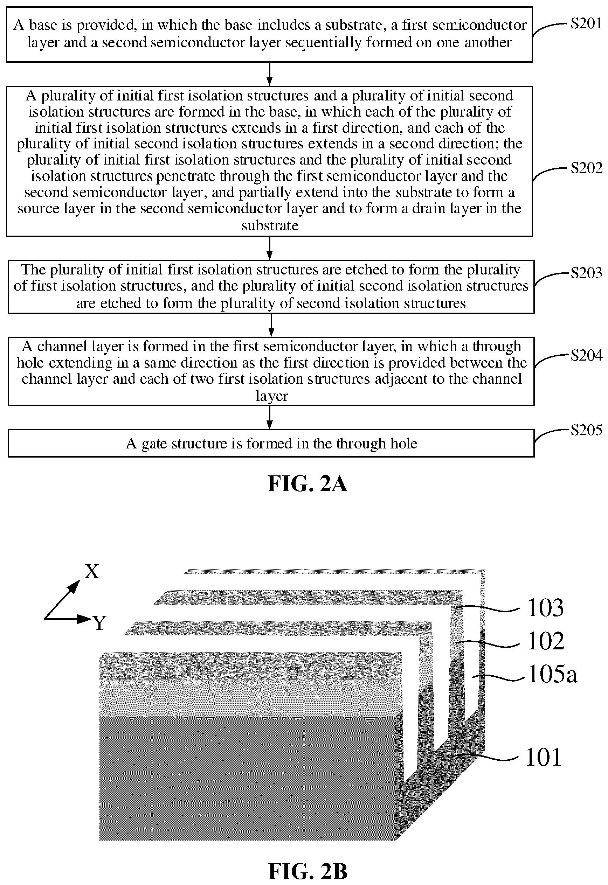

An embodiment of the application further provides a method for forming a semiconductor structure. As shown in FIG. 2A, the method includes the following operations.

In S201, a base is provided, in which the base includes a substrate, a first semiconductor layer and a second semiconductor layer sequentially formed on one another.

In S202, a plurality of initial first isolation structures and a plurality of initial second isolation structures are formed in the base, in which each of the plurality of initial first isolation structures extends in a first direction, and each of the plurality of initial second isolation structures extends in a second direction, and in which the plurality of initial first isolation structures and the plurality of initial second isolation structures penetrate through the first semiconductor layer and the second semiconductor layer, and partially extend into the substrate to form a source layer in the second semiconductor layer and to form a drain layer in the substrate.

In S203, the plurality of initial first isolation structures are etched to form the plurality of first isolation structures, and the plurality of initial second isolation structures are etched to form the plurality of second isolation structures.

In S204, a channel layer is formed in the first semiconductor layer, in which a through hole extending in a same direction as the first direction is provided between the channel layer and each of two first isolation structures adjacent to the channel layer.

In S205, a gate structure is formed in the through hole.

The operation that the plurality of first isolation structures spaced apart from each other and the plurality of second isolation structures spaced apart from each other are formed in the base in the above embodiment may be implemented through S201 to S203.

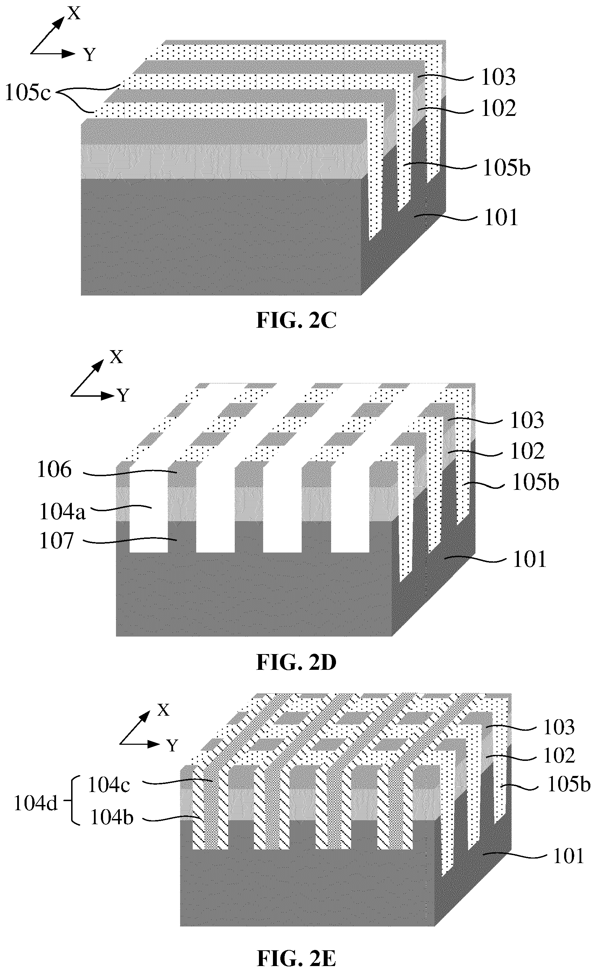

In some embodiments, S202 may be implemented through S221 and S222. S221 is implemented with reference to FIG. 2B to FIG. 2C, and S222 is implemented with reference to FIG. 2D to FIG. 2E.

In S221, with reference to FIG. 2B, a plurality of second isolation structure trenches 105a (in the Y-axis direction) is formed in the base (see the base 100 shown in FIG. 1B). With reference to FIG. 2C, the plurality of second isolation structure trenches (see the second isolation structure trench 105a shown in FIG. 2B) are filled with a first dielectric layer 105b to form the plurality of initial second isolation structures.

In S222, with reference to FIG. 2D, after the plurality of initial second isolation structures 105c are formed in the base (as shown in FIG. 2C), a plurality of first isolation structure trenches 104a (in the X-axis direction) are formed in the base. With reference to FIG. 2E, the plurality of first isolation structure trenches (see the first isolation structure trench 104a shown in FIG. 2D) are filled with a second dielectric layer 104b and a third dielectric layer 104c to form the plurality of initial first isolation structures 104d. The plurality of first isolation structure trenches (see the first isolation structure trench 104a shown in FIG. 2D) and the plurality of second isolation structure trenches (see the second isolation structure trench 105a shown in FIG. 2B) penetrate through the first semiconductor layer 102 and the second semiconductor layer 103, and partially extend into the substrate 101.

Herein, the first isolation structure trench and the second isolation structure trench may be formed through a self-aligned shallow trench isolation technology, for example, may be formed through a Self-aligned Double Patterning, SADP, process, or may be formed through a Self-aligned Quadruple Patterning, SAQP, process.

During implementation, firstly, a Sacrifice Layer (generally a CVD material) can be deposited on the surface of the base, and then photolithography and etching are performed to transfer the pattern on the mask to the sacrifice layer. The pattern on the sacrifice layer is also called a "mandrel" or "core". Atomic Layer Deposition, ALD is used for depositing a thin film (called a "spacer material") of a relatively uniform thickness on a surface and a side of the "mandrel". The deposited spacer material is then etched through a reactive ion etching process, and this operation is known as "etch back". Due to the geometric effect of a sidewall of the "mandrel", the material deposited on both sides of the pattern remains to form so-called spacer. The "mandrel" is removed by using a high-selectivity etchant, and only the spacer is remained on the surface of the base. A cycle of the spacer pattern is half of that of a photolithography pattern, so that doubling of the spatial pattern density is realized. Finally, the spacer pattern is transferred to a hard mask of the base through plasma etching.

Herein, the material of the first dielectric layer may be silicon oxide, for example, silicon dioxide, silicon oxynitride or silicon oxide doped with boron and phosphorus, or other suitable materials. The material of the second dielectric layer may be the same as or different from the material of the first dielectric layer. The first dielectric layer may be formed through thermal oxidation, Chemical Vapor Deposition, CVD, Atomic Layer Deposition, ALD, Plasma Enhanced Atomic Layer Deposition, PEALD, Low Pressure Chemical Vapor Deposition, LPCVD, or other suitable processes. The second dielectric layer may be formed through the same process as the first dielectric layer, or may be formed through a different process from the first dielectric layer.

The material of the third dielectric layer may be nitrides, such as silicon nitride, aluminum nitride (AlN), gallium nitride (GaN) and indium nitride (InN), and may be formed through a process such as LPCVD, Atmospheric Pressure Chemical Vapor Deposition, APCVD, or atomic layer deposition.

In some embodiments, the material of the first dielectric layer includes silicon oxide, and the material of the second dielectric layer is the same as the material of the first dielectric layer.

In some embodiments, in S222, the operation that the plurality of first isolation structure trenches are filled with the second dielectric layer and the third dielectric layer to form the plurality of initial first isolation structures may be implemented through S2221 to S2223.

In S2221, the plurality of first isolation structure trenches are filled with the second dielectric layer.

In S2222, the second dielectric layer at a bottom portion of each of the plurality of first isolation structure trenches and on a surface of the second semiconductor layer is removed.

In S2223, the plurality of first isolation structure trenches are filled with the third dielectric layer to form the plurality of initial first isolation structures.

In a practical application, the second dielectric layer at the bottom portion of each of the plurality of first isolation structure trenches may be removed through a dry etching process or a wet etching process. The dry etching process may be a plasma etching process, a reactive ion etching process, or an ion milling process. The second dielectric layer on the surface of the second semiconductor layer may be removed through a Chemical Mechanical Polish, CMP, process.

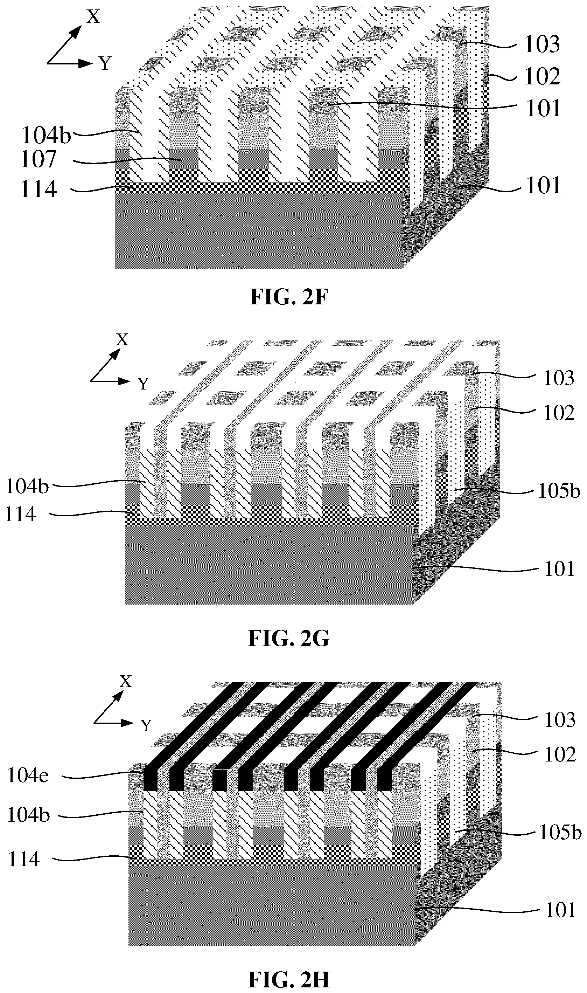

In some embodiments, the operations S222a and S222b are further included between S2222 and S2223, with reference to FIG. 2F. The operations are as follows.

In S222a, metal cobalt is deposited at the bottom portion of each of the plurality of first isolation structure trenches (see the first isolation structure trench 104a shown in FIG. 2D).

In S222b, annealing treatment is performed to form silicide in the substrate 101 to form a buried bit line 114, in which the drain layer 107 is arranged between the channel layer (see the channel layer 108 shown in FIG. 1E) and the buried bit line 114, and the plurality of initial second isolation structures penetrate through the buried bit line 114.

In a practical application, a substance deposited at the bottom portion of the first isolation structure trench is not limited to the metal cobalt, and may also be any one of titanium (Ti), tantalum (Ta), nickel (Ni), tungsten (W), platinum (Pt), and Palladium (Pd). The above metal can be deposited through CVD or ALD.

In a practical application, the annealing treatment allows the metal and the substrate to react with each other to achieve silicidation. Rapid annealing may be performed through rapid thermal annealing at different temperatures according the types of the deposited metal and the substrate. For example, if the metal material is cobalt, the annealing temperature may range from 400 °C to 800 °C. The metal silicide formed after silicidation may serve as the buried bit line.

The metal silicide is a substance with a lower resistance than that of polysilicon. With such a substance, the buried bit line has a low resistance. The buried bit line may be formed through a silicidation process. In addition, the buried bit line may be formed through a complete silicidation process. The complete silicidation process is a process for completely silicidating a silicon-containing substance to a desired depth. The buried bit line may be formed by using a near-noble metal such as titanium silicide (TiSiₓ), tungsten silicide (WSiₓ), cobalt silicide (CoSiₓ), and nickel silicide (NiSiₓ), or a metal silicide such as a refractory metal. The metal silicide may be obtained by forming a conductive material through a sputtering process, a CVD process or an ALD process, and then performing the silicidation process. The conductive material may include the near-noble metal or the refractory metal. The buried bit line is subjected to the complete silicidation, so that the resistance of the buried bit line may be reduced.

In some embodiments, S203 may be implemented through S231 to S233, and S231 to S232 are respectively shown in FIG. 2G to FIG. 2I.

In S231, with reference to FIG. 2E, the second dielectric layer 104b in the plurality of initial first isolation structures 104d in the second semiconductor 103 is etched, and the first dielectric layer 105b in the plurality of initial second isolation structures (see the description regarding to S221) in the second semiconductor layer 103 is etched, so that the structure shown in FIG. 2G can be formed.

In S232, with reference to FIG. 2G, the plurality of etched initial first isolation structures (see the initial first isolation structure 104d shown in FIG. 2E ) in the second semiconductor layer 103 are filled with a fourth dielectric layer 104e, so that the structure shown in FIG. 2H can be formed.

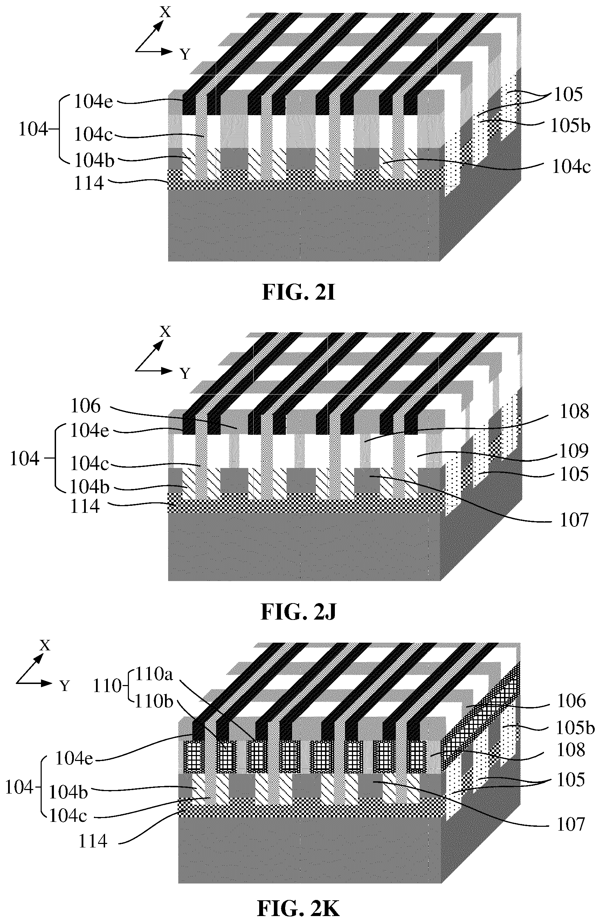

In S233, with reference to FIG. 2H, the second dielectric layer 104b in the plurality of initial first isolation structures (see the initial first isolation structure 104d shown in FIG. 2E) in the first semiconductor layer 102 is etched, and the first dielectric layer 105b in the plurality of initial second isolation structures (see the description regarding to S221) in the first semiconductor layer 102 is etched, so as to form the plurality of first isolation structures 104 and the plurality of second isolation structures 105, so that the structure shown in FIG. 2I can be formed.

Herein, each first isolation structure 104 includes the second dielectric layer 104b, the third dielectric layer 104c, and the fourth dielectric layer 104e.

In some embodiments, a material of the third dielectric layer includes silicon nitride, and a material of the fourth dielectric layer is the same as the material of the third dielectric layer.

In some embodiments, after S233, the method further includes S234, in which, with reference to FIG. 2I, a portion of the first semiconductor layer (see the first semiconductor layer 102 shown in FIG. 2H) is etched to form the channel layer 108 as shown in FIG. 2J. The through hole 109 extending in the same direction as the first direction is provided between the channel layer 108 and each of the two first isolation structures 104 adjacent to the channel layer.

During implementation, the first semiconductor layer may be etched along the first direction (i.e., the X-axis direction) through an isotropic quasi-atomic layer etching technology to form the channel layer. The dimension of the channel layer may be controlled, so that the control of the channel by the grate structure can be improved, while improving the switching speed.

S205 is performed. The structure shown in FIG. 2K is formed after the gate structure is formed in the through hole.

On the basis of the structure in FIG. 2K formed by the above method, an embodiment of the application provides a semiconductor structure. The semiconductor structure includes:
a base (see the base 100 shown in FIG. 1B), in which the base includes a substrate (see the substrate 101 shown in FIG. 1B), a first semiconductor layer (see the first semiconductor layer 102 shown in FIG. 1B), and a second semiconductor layer (see the second semiconductor layer 103 shown in FIG. 1B) which are sequentially formed on one another;
a plurality of first isolation structures 104 spaced apart from each other and a plurality of second isolation structures 105 spaced apart from each other in the base, in which each of the plurality of first isolation structures 104 extends in a first direction, each of the plurality of second isolation structures 105 extends in a second direction, the plurality of first isolation structures 104 penetrate through the first semiconductor layer and the second semiconductor layer and partially extend into the substrate, and the plurality of second isolation structures 105 are arranged in the substrate; each first isolation structure 104 includes: a second dielectric layer 104b arranged in the substrate, a fourth dielectric layer 104e arranged in the second semiconductor layer, and a third dielectric layer 104c penetrating through the first semiconductor layer and the second semiconductor layer and partially extending into the substrate; a side wall of the third dielectric layer 104c is in contact with each of the second dielectric layer 104b and the fourth dielectric layer 104e, and each of the plurality of second isolation structures 105 includes a first dielectric layer 105b arranged in the substrate;
a source layer 106 arranged in the second semiconductor layer;
a drain layer 107 arranged in the substrate;
a channel layer 108 arranged in the first semiconductor layer; and
a gate structure 110 arranged between the sidewall of the channel layer 108 and each sidewall of two first isolation structures 104 adjacent to the channel layer and extending in a same direction as the first direction, as shown in FIG. 2K, the gate structure 10 is in contact with the second dielectric 104b, the forth dielectric 104e and the sidewall of the third dielectric 104c, and the gate structure 10 is located between the second dielectric 104b and the forth dielectric forth dielectric 104e.
a buried bit line 114 arranged in the substrate and penetrated by the plurality of second isolation structures 105, in which the drain layer 107 is arranged between the channel layer 108 and the buried bit line 114, and a height of a portion of each of the plurality of first isolation structures 104 extending into the substrate is less than a height of a portion of each of the plurality of second isolation structures 105 arranged in the substrate.

An embodiment of the application further provides a method for forming a semiconductor structure, which includes the following operations.

In S301, as shown in FIG. 1B, a base 100 is provided, in which the base includes a substrate 101, a first semiconductor layer 102 and a second semiconductor layer 103 sequentially formed on one another.

In S302, ion doping is performed on the second semiconductor layer 103 and a portion of the substrate 101, so as to form a drain doped area in the substrate 101, and to form a source doped area in the second semiconductor layer 103.

Herein, the dopant used for ion doping may be an N-type dopant, such as phosphorus (P), arsenic (As), silicon (Si), germanium (Ge), carbon (C), oxygen (O), sulfur (S), selenium (Se), tellurium (Te), or antimony (Sb); and may also be a P-type dopant, such as boron (B), boron fluoride (BF₂), silicon, germanium, carbon, Zinc (Zn), cadmium (Cd), beryllium (Be), magnesium (Mg), or indium (In).

In S303, as shown in FIG. 1C, a plurality of first isolation structures 104 spaced apart from each other and a plurality of second isolation structures 105 spaced apart from each other are formed in the base (see the base 100 shown in FIG. 1B), in which a source layer 106 formed in the second semiconductor layer 103 and a drain layer 107 formed in the substrate 101 are provided between any two adjacent first isolation structures 104 of the plurality of first isolation structures, each of the plurality of first isolation structures 104 extends in a first direction, each of the plurality of second isolation structures 105 extends in a second direction, the plurality of first isolation structures 104 penetrate through the first semiconductor layer 102 and the second semiconductor layer 103 and partially extend into the substrate 101, and the plurality of second isolation structures are arranged in the substrate 101.

In S304, as shown in FIG. 1D, a channel layer 108 is formed in the first semiconductor layer 102, in which a through hole 109 extending in a same direction as the first direction is provided between the sidewall of the channel layer 108 and each sidewall of two first isolation structures 104 adjacent to the channel layer.

In S305, as shown in FIG. 1E, a gate structure 110 is formed in the through hole (see the through hole 109 shown in FIG. 1D).

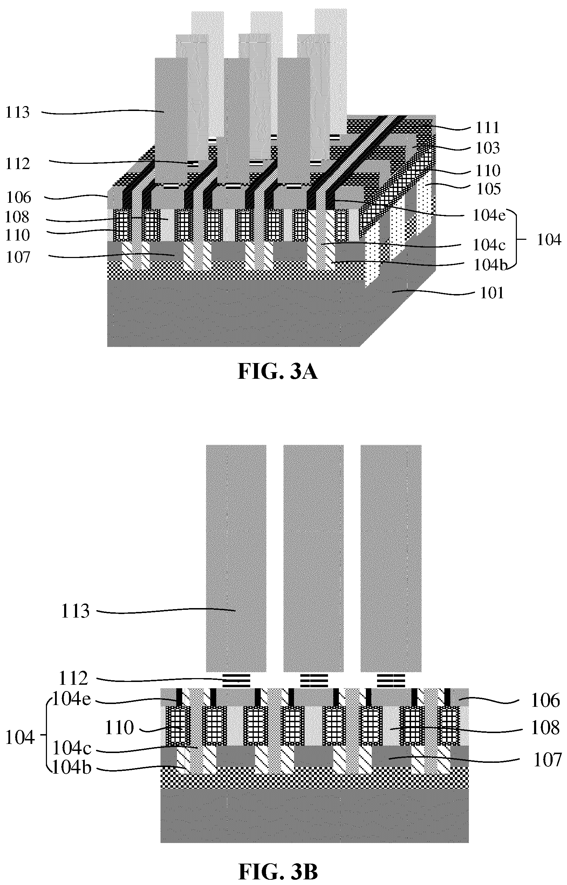

In S306, as shown in FIG. 3A, the second semiconductor layer 103 is filled with a fifth dielectric layer 111. A top surface of the fifth dielectric layer 111 is flush with a top surface of the second semiconductor layer 103.

Herein, a material of the fifth dielectric layer may be nitrides, such as silicon nitride, aluminum nitride (AlN), gallium nitride (GaN), and indium nitride (InN), and the fifth dielectric layer can be formed through a process such as low pressure chemical vapor deposition, atmospheric pressure chemical vapor deposition, or atomic layer deposition.

In S307, as shown in FIG. 3A, a contact node 112 and a capacitor 113 are sequentially formed on each source layer 106.

Herein, the capacitor may be a pillar capacitor, but may not be limited to a cylindrical capacitor. The capacitor may also be a square capacitor or a pillar capacitor of other shapes. The contact node may have a pillar shape or a concave structure.

In some embodiments, S305 may be implemented through S3051 and S3052.

In S3051, a gate oxide layer is formed in the through hole through thermal oxidation.

In S3052, a surface of the gate oxide layer is filled with a conductive material to form the gate structure.

In a practical application, the conductive material may be a metal, such as tungsten (W), or may be a metal nitride, such as titanium nitride.

In some embodiments, the capacitor may include an electrode plate and a dielectric layer. A material of the electrode plate may be titanium nitride (TiN) or aluminum foil, and a material of the dielectric layer may be a composite material of zirconia (ZrO) and aluminum oxide, a zirconia material, an aluminum oxide material or other materials with a higher dielectric constant than that of silicon dioxide.

In the embodiment of the application, the first isolation structures and the second isolation structures are formed in the base, the channel layer is formed in the first semiconductor layer, and the gate structure is formed in the through hole of the channel layer, so that a gate all round structure is formed, thereby improving the gate control capability and the switching speed.

The semiconductor structure formed by the above method is shown in FIG. 3A and FIG. 3B. Based on FIG. 3A, an embodiment of the application provides a semiconductor structure, which includes: a base (see the base 100 shown in FIG. 1B), in which the base includes a substrate 101, a first semiconductor layer 102 and a second semiconductor layer 103 sequentially formed on one another;
a plurality of first isolation structures 104 spaced apart from each other and a plurality of second isolation structures 105 spaced apart from each other in the base, in which each of the plurality of first isolation structures 104 extends in a first direction, each of the plurality of second isolation structures 105 extends in a second direction, the plurality of first isolation structures 104 penetrate through the first semiconductor layer 102 and the second semiconductor layer 103 and partially extend into the substrate 101, and the plurality of second isolation structures 105 are arranged in the substrate;
a source layer 106 arranged in the second semiconductor layer 103;
a drain layer 107 arranged in the substrate 101;
a channel layer 108 arranged in the first semiconductor layer 102;
a gate structure 110 arranged between the sidewall of the channel layer 108 and each sidewall of two first isolation structures 104 adjacent to the channel layer and extending in a same direction as the first direction.
a fifth dielectric layer 111 arranged in the second semiconductor layer 103, in which a top surface of the fifth dielectric layer 111 is flush with a top surface of the second semiconductor layer 103;
a contact node 112 and a capacitor 113 arranged on each source layer 106.

In some embodiments, as shown in FIG. 3A, the structure further includes a buried bit line 114 arranged in the substrate (see the substrate 101 shown in FIG. 3A) and penetrated by the plurality of second isolation structures 105. The drain layer 107 is arranged between the channel layer 108 and the buried bit line 114. A height of a portion of each of the plurality of first isolation structures 104 extending into the substrate is less than a height of a portion of each of the plurality of second isolation structures 105 arranged in the substrate.

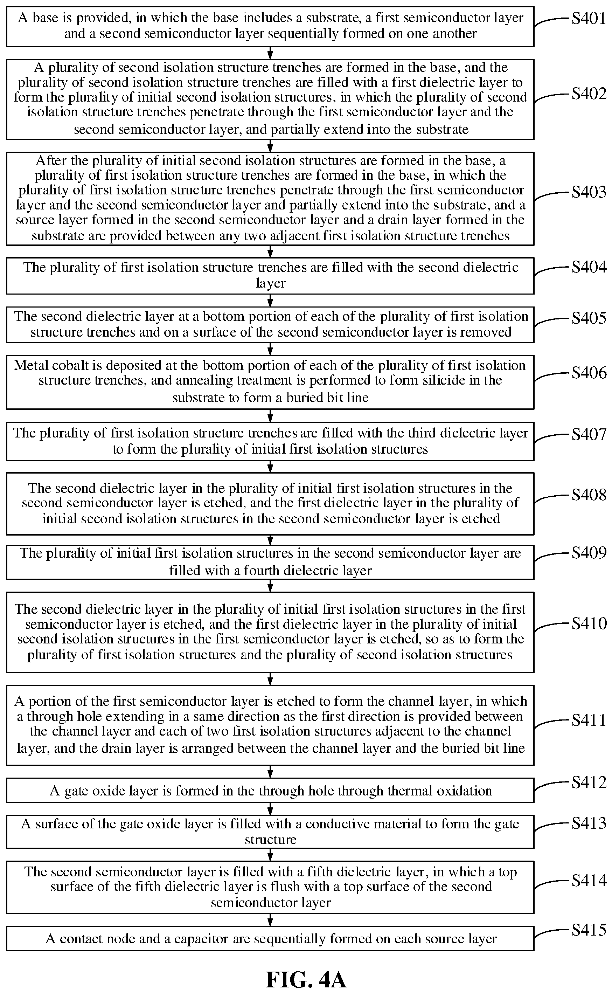

An embodiment of the application further provides a method for forming a semiconductor structure. With reference to FIG. 4A, the method includes the following operations.

In S401, as shown in FIG. 1B, a base 100 is provided, in which the base 100 includes a substrate 101, a first semiconductor layer 102 and a second semiconductor layer 103 sequentially formed on one another.

In S402, with reference to FIG. 2B, a plurality of second isolation structure trenches 105a are formed in the base (see the base 100 shown in FIG. 1B); and with reference to FIG. 2C, the plurality of second isolation structure trenches (see the second isolation structure trench 105a shown in FIG. 2C) are filled with a first dielectric layer 105b to form the plurality of initial second isolation structures.

The plurality of second isolation structure trenches 105a penetrate through the first semiconductor layer 102 and the second semiconductor layer 103, and partially extend into the substrate 101.

In S403, with reference to FIG. 2D, after the plurality of initial second isolation structures are formed in the base, a plurality of first isolation structure trenches 104a are formed in the base, in which the plurality of first isolation structure trenches 104a penetrate through the first semiconductor layer 102 and the second semiconductor layer 103 and partially extend into the substrate 101, and the source layer 106 formed in the second semiconductor layer 103 and the drain layer 107 formed in the substrate 101 are provided between any two adjacent first isolation structure trenches 104a.

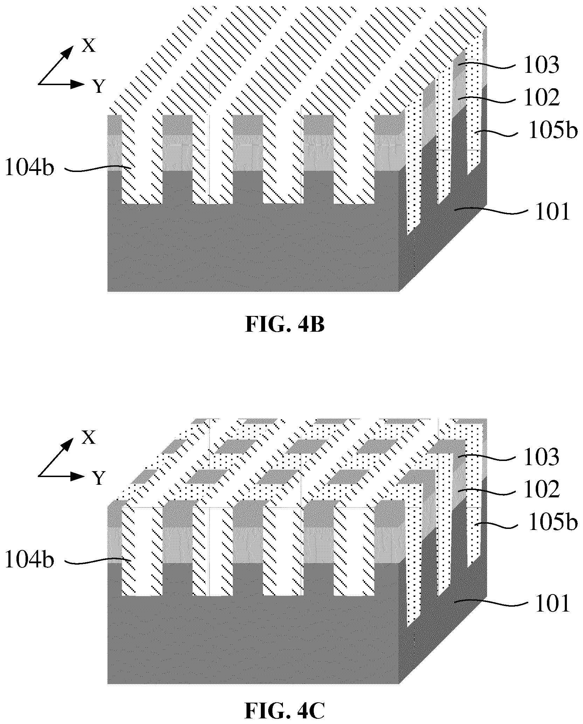

In S404, with reference to FIG. 2D and FIG. 4B, the plurality of first isolation structure trenches 104a shown in FIG. 2D are filled with the second dielectric layer 104b, so that the structure shown in FIG. 4B can be formed.

In S405, with reference to FIG. 4B, the second dielectric layer 104b at a bottom portion of each of the plurality of first isolation structure trenches (see the first isolation structure trench 104a shown in FIG. 2D) and on a surface of the second semiconductor layer 103 is removed, so that the structure shown in FIG. 4C can be formed.

In S406, metal cobalt is deposited at the bottom portion of each of the plurality of first isolation structure trenches (see the first isolation structure trench 104a shown in FIG. 4A); and with reference to FIG. 2F, annealing treatment is performed to form silicide in the substrate to form a buried bit line 114.

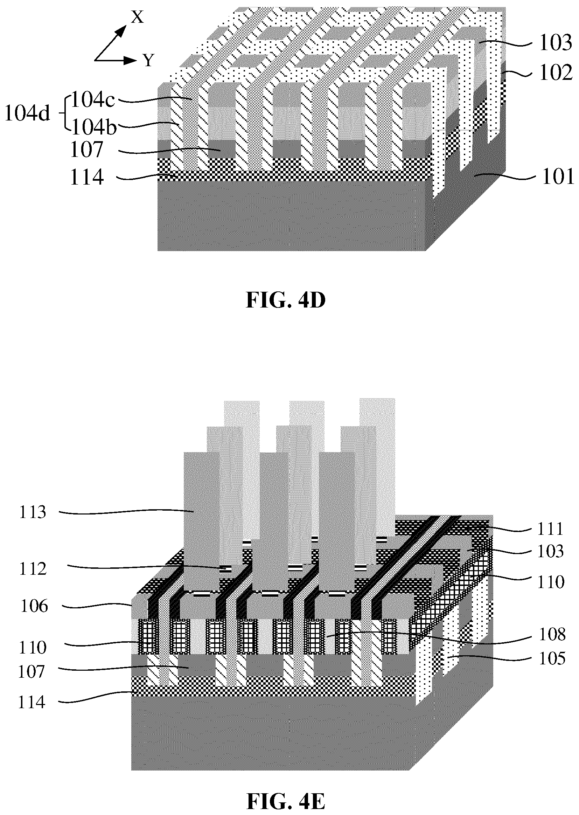

In S407, with reference to FIG. 4D, the plurality of first isolation structure trenches (see the first isolation structure trench 104a shown in FIG. 2D) are filled with the third dielectric layer 104c to form the plurality of initial first isolation structures 104d.

In S408, with reference to FIG. 2E, the second dielectric layer 104b in the plurality of initial first isolation structures (see the initial first isolation structure 104d shown in FIG. 4D) in the second semiconductor layer 103 is etched, and the first dielectric layer 105b in the plurality of initial second isolation structures (see the description regarding to S221) in the second semiconductor layer 103 is etched, so that the structure shown in FIG. 2G can be formed.

In S409, with reference to FIG. 2G, the plurality of etched initial first isolation structures (see the initial first isolation structure 104d shown in FIG. 4D ) in the second semiconductor layer 103 are filled with a fourth dielectric layer 104e, so that the structure shown in FIG. 2H can be formed.

In S410, with reference to FIG. 2H, the second dielectric layer 104b in the plurality of initial first isolation structures (see the initial first isolation structure 104d shown in FIG. 4D) in the first semiconductor layer 102 is etched, and the first dielectric layer 105b in the plurality of initial second isolation structures (see the description regarding to S221) in the first semiconductor layer 102 is etched, so as to form the plurality of first isolation structures 104 and the plurality of second isolation structures 105, so that the structure shown in FIG. 2I can be formed.

In S411, with reference to FIG. 2I, a portion of the first semiconductor layer (see the first semiconductor layer 102 shown in FIG. 2H) is etched to form the channel layer 108 shown in FIG. 2J, in which a through hole 109 extending in a same direction as the first direction is provided between the sidewall of the channel layer 108 and each sidewall of two first isolation structures 104 adjacent to the channel layer, a width of the channel layer 108 in the second direction is less than each of a width of the source layer 106 and a width of the drain layer 107 in the second direction, and the drain layer 107 is arranged between the channel layer 108 and the buried bit line 114.

In S412, with reference to FIG. 2K, a gate oxide layer 110a is formed in the through hole (see the through hole 109 shown in FIG. 2J) through thermal oxidation.

In S413, with reference to FIG. 2K, a surface of the gate oxide layer 110a is filled with a conductive material 110b to form the gate structure 110, the gate structure 10 is in contact with the second dielectric104b, the forth dielectric 104e and the sidewall of the third dielectric 104c, and the gate structure 10 is located between the second dielectric 104b and the forth dielectric forth dielectric104e.

In S414, with reference to FIG. 4E, the second semiconductor layer 103 is filled with a fifth dielectric layer 111, in which a top surface of the fifth dielectric layer 111 is flush with a top surface of the second semiconductor layer 103.

In S415, with reference to FIG. 4E, a contact node 112 and a capacitor 113 are sequentially formed on each source layer 106.

The above description of the semiconductor structure embodiment is similar to the description of the above method embodiment, and has beneficial effects similar to that of the method embodiment. The understanding for technical details not disclosed in the semiconductor structure embodiments of the application refer to the description of the method embodiments of the application.

In the several embodiments provided in the application, it should be understood that the disclosed device and method may be implemented in non-target manners. The described device embodiments are merely exemplary. For example, the unit division is merely logical function division and may be other division in an actual implementation. For example, a plurality of units or components may be combined or integrated into another system, or some features may be ignored or not performed. In addition, the displayed or discussed components may be coupled or directly coupled to each other.

The units described above as separate components may or may not be physically separated. Components presented as units may or may not be physical units, that is, may be located in one place or may be distributed over multiple network units. Part or all of these units may be selected according to practical requirements to achieve the objectives of the solutions of the embodiment.

The features disclosed in the several method or structure embodiments provided in the application may be combined with each other arbitrarily without conflict, so as to obtain new method embodiments or structure embodiments.

The above are only some embodiments of the embodiments of the application, but the protection scope of the embodiments of the application is not limited thereto. Any skilled in the art, within the technical scope disclosed by the embodiments of the application, may easily think of variations or replacements, which should be covered within the protection scope of the embodiments of the application. Therefore, the protection scope of the embodiments of the application should be subject to the protection scope of the claims.

### Industrial applicability

The embodiments of the application provide a semiconductor structure and a method for forming a semiconductor structure. The method for forming the semiconductor structure includes the following operations. A base is provided, in which the base includes a substrate, a first semiconductor layer and a second semiconductor layer sequentially formed on one another. A plurality of first isolation structures spaced apart from each other and a plurality of second isolation structures spaced apart from each other are formed in the base, in which a source layer formed in the second semiconductor layer and a drain layer formed in the substrate are provided between any two adjacent first isolation structures of the plurality of first isolation structures, each of the plurality of first isolation structures extends in a first direction, each of the plurality of second isolation structures extends in a second direction, the plurality of first isolation structures penetrate through the first semiconductor layer and the second semiconductor layer and partially extend into the substrate, and the plurality of second isolation structures are arranged in the substrate. A channel layer is formed in the first semiconductor layer, in which a through hole extending in a same direction as the first direction is provided between the channel layer and each of two first isolation structures adjacent to the channel layer. A gate structure is formed in the through hole. In the embodiments of the application, gate self-alignment is realized and a gate-all-around structure is formed, thereby improving the gate control capability and the switching speed.

## Claims

1. A method for forming a semiconductor structure, **characterized in that** the method comprises:
providing (S101, S201, S301, S401) a base (100), wherein the base (100) comprises a substrate (101), a first semiconductor layer (102) and a second semiconductor layer (103) sequentially formed on one another;
forming (S102) a plurality of first isolation structures (104) spaced apart from each other and a plurality of second isolation structures (105) spaced apart from each other in the base (100), comprises
forming (S221, S402) a plurality of second isolation structure trenches (105a) in the base (100), and filling the plurality of second isolation structure trenches (105a) with a first dielectric layer (105b) to form a plurality of initial second isolation structures (105c); and
after forming the plurality of initial second isolation structures (105c) in the base (100), forming (S222) a plurality of first isolation structure trenches (104a) in the base (100), and filling (S2221, S404) the plurality of first isolation structure trenches (104a) with a second dielectric layer (104b);
removing (S2222, S405) the second dielectric layer (104b) at a bottom portion of each of the plurality of first isolation structure trenches (104a) and on a surface of the second semiconductor layer (103); and
filing (S2223, S407) the plurality of first isolation structure trenches (104a) with a third dielectric layer (104c) to form a plurality of initial first isolation structures (104d),
etching (S231, S408) the second dielectric layer (104b) in the plurality of initial first isolation structures (104d) in the second semiconductor layer (103), and etching the first dielectric layer (105b) in the plurality of initial second isolation structures (105c) in the second semiconductor layer (103);
filling (S232, S409) the plurality of etched initial first isolation structures (104d) in the second semiconductor layer (103) with a fourth dielectric layer (104e); and
etching (S233, S410) the second dielectric layer (104b) in the plurality of initial first isolation structures (104d) in the first semiconductor layer (102), and etching the first dielectric layer (105b) in the plurality of initial second isolation structures (105c) in the first semiconductor layer (102) to form the plurality of first isolation structures (104) and the plurality of second isolation structures (105),
wherein a source layer (106) formed in the second semiconductor layer (103) and a drain layer (107) formed in the substrate (101) are provided between any two adjacent first isolation structures (104) of the plurality of first isolation structures (104), each of the plurality of first isolation structures (104) extends in a first direction, each of the plurality of second isolation structures (105) extends in a second direction, the plurality of first isolation structures (104) penetrate through the first semiconductor layer (102) and the second semiconductor layer (103) and partially extend into the substrate (101), and the plurality of second isolation structures (105) are arranged in the substrate (101);
etching (S234, S411) a portion of the first semiconductor layer (102) to form (S103, S204, S304) a channel layer (108) in the first semiconductor layer (102), wherein a through hole (109) extending in a same direction as the first direction is provided between the channel layer (108) and each of two first isolation structures (104) adjacent to the channel layer (108); and
forming (S104, S205, S305) a gate structure (110) in the through hole (109).

2. The method according to claim 1, wherein the method, before forming (S102) the plurality of first isolation structures (104) spaced apart from each other and the plurality of second isolation structures (105) spaced apart from each other in the base (100), further comprises:
performing (S302) ion doping on the second semiconductor layer (103) and a portion of the substrate (101) to form a drain doped area in the substrate (101), and to form a source doped area in the second semiconductor layer (103).

3. The method according to claim 1, wherein each of the plurality of initial first isolation structures (104d) extends in the first direction, and each of the plurality of initial second isolation structures (105c) extends in the second direction, and wherein the plurality of initial first isolation structures (104d) and the plurality of initial second isolation structures (105c) penetrate through the first semiconductor layer (102) and the second semiconductor layer (103), and partially extend into the substrate (101) to form the source layer (106) in the second semiconductor layer (103) and to form the drain layer (107) in the substrate (101)

4. The method according to claim 3, wherein the plurality of first isolation structure trenches (104a) and the plurality of second isolation structure trenches (105a) penetrate through the first semiconductor layer (102) and the second semiconductor layer (103), and partially extend into the substrate (101).

5. The method according to claim4, wherein the method, after etching (S233, S410) the second dielectric layer (104b) in the plurality of initial first isolation structures (104d) in the first semiconductor layer (102) and etching the first dielectric layer (105b) in the plurality of initial second isolation structures (105c) in the first semiconductor layer (102), comprises:
etching (S234, S411) a portion of the first semiconductor layer (102) to form the channel layer (108), wherein the through hole (109) extending in the same direction as the first direction is provided between the channel layer (108) and each of the two first isolation structures (104) adjacent to the channel layer (108), and a width of the channel layer (108) in the second direction is less than each of a width of the source layer (106) and a width of the drain layer (107) in the second direction.

6. The method according to claim1, wherein the method, after removing (S2222, S405) the second dielectric layer (104b) at the bottom portion of each of the plurality of first isolation structure trenches (104a) and on the surface of the second semiconductor layer (103), and before filing (S2223, S407) the plurality of first isolation structure trenches (104a) with the third dielectric layer (104c), further comprises:
depositing (S222a, S406) metal cobalt at the bottom portion of each of the plurality of first isolation structure trenches (104a); and
performing (S222b) an annealing treatment to form silicide in the substrate (101) to form a buried bit line (114), wherein the drain layer (107) is arranged between the channel layer (108) and the buried bit line (114), a height of a portion of each of the plurality of first isolation structures (104) extending into the substrate (101) is less than a height of a portion of each of the plurality of second isolation structures (105) arranged in the substrate (101), and the plurality of second isolation structures (105) penetrate through the buried bit line (114).

7. The method according to any one of claims 1 to6, wherein forming (S104, S205, S305) the gate structure (110) in the through hole (109) comprises:
forming (S3051, S412) a gate oxide layer (110a) in the through hole (109) through thermal oxidation; and
filling (S3052, S413) a surface of the gate oxide layer (110a) with a conductive material (110b) to form the gate structure (110).

8. The method according to claim7, further comprising:
filling (S306) the second semiconductor layer (103) with a fifth dielectric layer (111), wherein a top surface of the fifth dielectric layer (111) is flush with a top surface of the second semiconductor layer (103); and
sequentially forming (S307) a contact node (112) and a capacitor (113) on the source layer (106),
preferably, a material of the gate oxide layer (110a) comprises silicon oxide, and a material of the fifth dielectric layer (111) comprises silicon nitride.

9. The method according to claim 6, wherein a material of the first dielectric layer (105b) comprises silicon oxide, and a material of the second dielectric layer (104b) is the same as the material of the first dielectric layer (105b), and wherein a material of the third dielectric layer (104c) comprises silicon nitride, and a material of the fourth dielectric layer (104e) is the same as the material of the third dielectric layer (104c).

10. A semiconductor structure, comprising:
a base (100), wherein the base (100) comprises a substrate (101), a first semiconductor layer (102) and a second semiconductor layer (103) sequentially formed on one another;
a plurality of first isolation structures (104) spaced apart from each other and a plurality of second isolation structures (105) spaced apart from each other in the base (100), wherein each of the plurality of first isolation structures (104) extends in a first direction, each of the plurality of second isolation structures (105) extends in a second direction, the plurality of first isolation structures (104) penetrate through the first semiconductor layer (102) and the second semiconductor layer (103) and partially extend into the substrate (101), and the plurality of second isolation structures (105) are arranged in the substrate (101);
a source layer (106) arranged in the second semiconductor layer (103);
a drain layer (107) arranged in the substrate (101);
a channel layer (108) arranged in the first semiconductor layer (102); and
a gate structure (110) arranged between the channel layer (108) and each of two first isolation structures (104) adjacent to the channel layer (108) and extending in a same direction as the first direction, **characterized in that**, wherein each of the plurality of first isolation structures (104) comprises: a second dielectric layer (104b) arranged in the substrate (101), a fourth dielectric layer (104e) arranged in the second semiconductor layer (103), and a third dielectric layer (104c) penetrating through the first semiconductor layer (102) and the second semiconductor layer (103) and partially extending into the substrate (101), and wherein a side wall of the third dielectric layer (104c) is in contact with each of the second dielectric layer (104b) and the fourth dielectric layer (104e), wherein the gate structure (10) is in contact with the second dielectric (104b), the fourth dielectric (104e) and the sidewall of the third dielectric (104c), and the gate structure (10) is located between the second dielectric (104b) and the fourth dielectric (104e), and each of the plurality of second isolation structures (105) comprises a first dielectric layer (105b) arranged in the substrate (101),
preferably, the semiconductor structure further comprises: a buried bit line (114) arranged in the substrate (101) and penetrated by the plurality of second isolation structures (105), wherein the drain layer (107) is arranged between the channel layer (108) and the buried bit line (114), and a height of a portion of each of the plurality of first isolation structures (104) extending into the substrate (101) is less than a height of a portion of each of the plurality of second isolation structures (105) arranged in the substrate (101),
preferably, a material of the first dielectric layer comprises silicon oxide, and a material of the second dielectric layer is the same as the material of the first dielectric layer, and wherein a material of the third dielectric layer comprises silicon nitride, and a material of the fourth dielectric layer is the same as the material of the third dielectric layer.

11. The structure according to claim 10, wherein the substrate is a silicon substrate, the first semiconductor layer is a silicon germanium layer, and the second semiconductor layer is a silicon layer,
preferably, the gate structure comprises a gate oxide layer, and a conductive material on a surface of the gate oxide layer.

12. The semiconductor structure according to any one of claims 10 to 11, further comprising:
a fifth dielectric layer arranged in the second semiconductor layer, wherein a top surface of the fifth dielectric layer is flush with a top surface of the second semiconductor layer; and
a contact node and a capacitor arranged on the source layer.

## Patentansprüche

1. Verfahren zur Herstellung einer Halbleiterstruktur, **dadurch gekennzeichnet, dass** das Verfahren Folgendes umfasst:
Bereitstellen (S101, S201, S301, S401) einer Basis (100), wobei die Basis (100) ein Substrat (101), eine erste Halbleiterschicht (102) und eine zweite Halbleiterschicht (103) umfasst, die nacheinander aufeinander gebildet sind;
Bilden (S102) einer Vielzahl von ersten Isolationsstrukturen (104), die voneinander beabstandet sind, und einer Vielzahl von zweiten Isolationsstrukturen (105), die voneinander beabstandet sind, in der Basis (100), umfassend
Bilden (S221, S402) einer Vielzahl von zweiten Isolationsstrukturgräben (105a) in der Basis (100) und Füllen der Vielzahl von zweiten Isolationsstrukturgräben (105a) mit einer ersten dielektrischen Schicht (105b), um eine Vielzahl von anfänglichen zweiten Isolationsstrukturen (105c) zu bilden; und
nach Bilden der Vielzahl von anfänglichen zweiten Isolationsstrukturen (105c) in der Basis (100), Bilden (S222) einer Vielzahl von ersten Isolationsstrukturgräben (104a) in der Basis (100), und Füllen (S2221, S404) der Vielzahl von ersten Isolationsstrukturgräben (104a) mit einer zweiten dielektrischen Schicht (104b);
Entfernen (S2222, S405) der zweiten dielektrischen Schicht (104b) an einem unteren Abschnitt von jedem der Vielzahl von ersten Isolationsstrukturgräben (104a) und auf einer Oberfläche der zweiten Halbleiterschicht (103); und
Füllen (S2223, S407) der Vielzahl von ersten Isolationsstrukturgräben (104a) mit einer dritten dielektrischen Schicht (104c), um eine Vielzahl von anfänglichen ersten Isolationsstrukturen (104d) zu bilden,
Ätzen (S231, S408) der zweiten dielektrischen Schicht (104b) in der Vielzahl von anfänglichen ersten Isolationsstrukturen (104d) in der zweiten Halbleiterschicht (103), und Ätzen der ersten dielektrischen Schicht (105b) in der Vielzahl von anfänglichen zweiten Isolationsstrukturen (105c) in der zweiten Halbleiterschicht (103);
Füllen (S232, S409) der Vielzahl von geätzten anfänglichen ersten Isolationsstrukturen (104d) in der zweiten Halbleiterschicht (103) mit einer vierten dielektrischen Schicht (104e); und
Ätzen (S233, S410) der zweiten dielektrischen Schicht (104b) in der Vielzahl von anfänglichen ersten Isolationsstrukturen (104d) in der ersten Halbleiterschicht (102), und Ätzen der ersten dielektrischen Schicht (105b) in der Vielzahl von anfänglichen zweiten Isolationsstrukturen (105c) in der ersten Halbleiterschicht (102), um die Vielzahl von ersten Isolationsstrukturen (104) und die Vielzahl von zweiten Isolationsstrukturen (105) zu bilden,
wobei eine Source-Schicht (106), die in der zweiten Halbleiterschicht (103) gebildet ist, und eine Drain-Schicht (107), die in dem Substrat (101) gebildet ist, zwischen zwei beliebigen angrenzenden ersten Isolationsstrukturen (104) der Vielzahl der ersten Isolationsstrukturen (104) bereitgestellt sind, jede der Vielzahl von ersten Isolierstrukturen (104) sich in eine erste Richtung erstreckt, jede der Vielzahl von zweiten Isolierstrukturen (105) sich in eine zweite Richtung erstreckt, die Vielzahl der ersten Isolationsstrukturen (104) die erste Halbleiterschicht (102) und die zweite Halbleiterschicht (103) durchdringen und sich teilweise in das Substrat (101) erstrecken, und die Vielzahl der zweiten Isolationsstrukturen (105) in dem Substrat (101) angeordnet sind;
Ätzen (S234, S411) eines Abschnitts der ersten Halbleiterschicht (102), um eine Kanalschicht (108) in der ersten Halbleiterschicht (102) zu bilden (S103, S204, S304), wobei ein Durchgangsloch (109), das sich in der gleichen Richtung wie die erste Richtung erstreckt, zwischen der Kanalschicht (108) und jeder von zwei ersten Isolationsstrukturen (104) angrenzend an die Kanalschicht (108) bereitgestellt ist; und
Bilden (S104, S205, S305) einer Gate-Struktur (110) in dem Durchgangsloch (109).

2. Verfahren nach Anspruch 1, wobei das Verfahren vor Bilden (S102) der Vielzahl von ersten Isolationsstrukturen (104), die voneinander beabstandet sind, und der Vielzahl von zweiten Isolationsstrukturen (105), die voneinander beabstandet sind, in der Basis (100) ferner Folgendes umfasst:
Durchführen (S302) von Ionendotieren auf der zweiten Halbleiterschicht (103) und einem Abschnitt des Substrats (101), um einen Drain-dotierten Bereich in dem Substrat (101) zu bilden, und um einen Source-dotierten Bereich in der zweiten Halbleiterschicht (103) zu bilden.

3. Verfahren nach Anspruch 1, wobei sich jede der Vielzahl von anfänglichen ersten Isolationsstrukturen (104d) in die erste Richtung erstreckt und sich jede der Vielzahl von anfänglichen zweiten Isolationsstrukturen (105c) in die zweite Richtung erstreckt, und wobei die Vielzahl von anfänglichen ersten Isolationsstrukturen (104d) und die Vielzahl von anfänglichen zweiten Isolationsstrukturen (105c) die erste Halbleiterschicht (102) und die zweite Halbleiterschicht (103) durchdringen und sich teilweise in das Substrat (101) erstrecken, um die Source-Schicht (106) in der zweiten Halbleiterschicht (103) zu bilden und die Drain-Schicht (107) in dem Substrat (101) zu bilden

4. Verfahren nach Anspruch 3, wobei die Vielzahl von ersten Isolationsstrukturgräben (104a) und die Vielzahl von zweiten Isolationsstrukturgräben (105a) die erste Halbleiterschicht (102) und die zweite Halbleiterschicht (103) durchdringen und sich teilweise in das Substrat (101) erstrecken.

5. Verfahren nach Anspruch4, wobei das Verfahren nach Ätzen (S233, S410) der zweiten dielektrischen Schicht (104b) in der Vielzahl von anfänglichen ersten Isolationsstrukturen (104d) in der ersten Halbleiterschicht (102) und Ätzen der ersten dielektrischen Schicht (105b) in der Vielzahl von anfänglichen zweiten Isolationsstrukturen (105c) in der ersten Halbleiterschicht (102) Folgendes umfasst:
Ätzen (S234, S411) eines Abschnitts der ersten Halbleiterschicht (102), um die Kanalschicht (108) zu bilden, wobei sich das Durchgangsloch (109), das sich in die gleiche Richtung wie die erste Richtung erstreckt, zwischen der Kanalschicht (108) und jeder der beiden ersten Isolationsstrukturen (104) angrenzend an die Kanalschicht (108) bereitgestellt ist, und eine Breite der Kanalschicht (108) in der zweiten Richtung kleiner ist als eine Breite der Source-Schicht (106) und eine Breite der Drain-Schicht (107) in der zweiten Richtung.

6. Verfahren nach Anspruch 1, wobei das Verfahren nach Entfernen (S2222, S405) der zweiten dielektrischen Schicht (104b) an dem unteren Abschnitt von jedem der Vielzahl von ersten Isolationsstrukturgräben (104a) und auf der Oberfläche der zweiten Halbleiterschicht (103) und vor Füllen (S2223, S407) der Vielzahl von ersten Isolationsstrukturgräben (104a) mit der dritten dielektrischen Schicht (104c) ferner Folgendes umfasst:
Aufbringen (S222a, S406) von metallischem Kobalt an dem unteren Abschnitt von jedem der Vielzahl von ersten Isolationsstrukturgräben (104a); und
Durchführen (S222b) einer Glühbehandlung zum Bilden von Silizid in dem Substrat (101), um eine vergrabene Bitleitung (114) zu bilden, wobei die Drain-Schicht (107) zwischen der Kanalschicht (108) und der vergrabenen Bitleitung (114) angeordnet ist, eine Höhe eines Abschnitts jeder der Vielzahl von ersten Isolationsstrukturen (104), die sich in das Substrat (101) erstrecken, geringer ist als eine Höhe eines Abschnitts jeder der Vielzahl von zweiten Isolationsstrukturen (105), die in dem Substrat (101) angeordnet sind, und die Vielzahl von zweiten Isolationsstrukturen (105) die vergrabene Bitleitung (114) durchdringen.

7. Verfahren nach einem der Ansprüche 1 bis6, wobei ein Bilden (S104, S205, S305) der Gate-Struktur (110) in dem Durchgangsloch (109) Folgendes umfasst:
Bilden (S3051, S412) einer Gate-Oxidschicht (110a) in dem Durchgangsloch (109) durch thermische Oxidation; und
Füllen (S3052, S413) einer Oberfläche der Gate-Oxidschicht (110a) mit einem leitenden Material (110b), um die Gate-Struktur (110) zu bilden.

8. Verfahren nach Anspruch 7, ferner umfassend:
Füllen (S306) der zweiten Halbleiterschicht (103) mit einer fünften dielektrischen Schicht (111), wobei eine obere Fläche der fünften dielektrischen Schicht (111) mit einer oberen Fläche der zweiten Halbleiterschicht (103) bündig ist; und
sequentielles Bilden (S307) eines Kontaktknotens (112) und eines Kondensators (113) auf der Source-Schicht (106),
wobei vorzugsweise ein Material der Gate-Oxidschicht (110a) Siliziumoxid umfasst und ein Material der fünften dielektrischen Schicht (111) Siliziumnitrid umfasst.

9. Verfahren nach Anspruch 6, wobei ein Material der ersten dielektrischen Schicht (105b) Siliziumoxid umfasst, und ein Material der zweiten dielektrischen Schicht (104b) gleich ist wie das Material der ersten dielektrischen Schicht (105b), und wobei ein Material der dritten dielektrischen Schicht (104c) Siliziumnitrid umfasst, und ein Material der vierten dielektrischen Schicht (104e) gleich ist wie das Material der dritten dielektrischen Schicht (104c).

10. Halbleiterstruktur, umfassend:
eine Basis (100), wobei die Basis (100) ein Substrat (101), eine erste Halbleiterschicht (102) und eine zweite Halbleiterschicht (103) umfasst, die nacheinander aufeinander gebildet sind;
eine Vielzahl von ersten Isolationsstrukturen (104), die voneinander beabstandet sind, und eine Vielzahl von zweiten Isolationsstrukturen (105), die voneinander beabstandet sind, in der Basis (100), wobei sich jede der Vielzahl von ersten Isolierstrukturen (104) in eine erste Richtung erstreckt, jede der Vielzahl von zweiten Isolierstrukturen (105) sich in eine zweite Richtung erstreckt, die Vielzahl der ersten Isolationsstrukturen (104) die erste Halbleiterschicht (102) und die zweite Halbleiterschicht (103) durchdringen und sich teilweise in das Substrat (101) erstrecken, und die Vielzahl der zweiten Isolationsstrukturen (105) in dem Substrat (101) angeordnet sind;
eine Source-Schicht (106), die in der zweiten Halbleiterschicht (103) angeordnet ist;
eine Drain-Schicht (107), die in dem Substrat (101) angeordnet ist;
eine Kanalschicht (108), die in der ersten Halbleiterschicht (102) angeordnet ist; und
eine Gate-Struktur (110), die zwischen der Kanalschicht (108) und jeder der zwei ersten Isolationsstrukturen (104) angrenzend an die Kanalschicht (108) angeordnet ist und sich in die gleiche Richtung wie die erste Richtung erstrecken, **dadurch gekennzeichnet, dass** jede der Vielzahl von ersten Isolierstrukturen (104) Folgendes umfasst:eine zweite dielektrische Schicht (104b), die in dem Substrat (101) angeordnet ist, eine vierte dielektrische Schicht (104e), die in der zweiten Halbleiterschicht (103) angeordnet ist, und eine dritte dielektrische Schicht (104c), die die erste Halbleiterschicht (102) und die zweite Halbleiterschicht (103) durchdringt und sich teilweise in das Substrat (101) erstreckt, und wobei eine Seitenwand der dritten dielektrischen Schicht (104c) in Kontakt mit jeder der zweiten dielektrischen Schicht (104b) und der vierten dielektrischen Schicht (104e) ist, wobei die Gate-Struktur (10) in Kontakt mit der zweiten dielektrischen Schicht (104b), der vierten
dielektrischen Schicht (104e) und der Seitenwand der
dritten dielektrischen Schicht (104c) ist, und sich die Gate-Struktur (10) zwischen der zweiten dielektrischen Schicht (104b) und der vierten
dielektrischen Schicht (104e) befindet, und jede der Vielzahl von zweiten Isolationsstrukturen (105) eine erste dielektrische Schicht (105b) umfasst, die in dem Substrat (101) angeordnet ist,
wobei die Halbleiterstruktur vorzugsweise ferner Folgendes umfasst: eine vergrabene Bitleitung (114), die in dem Substrat (101) angeordnet ist und von der Vielzahl der zweiten Isolationsstrukturen (105) durchdrungen wird, wobei die Drain-Schicht (107) zwischen der Kanalschicht (108) und der vergrabenen Bitleitung (114) angeordnet ist, und eine Höhe eines Abschnitts jeder der Vielzahl von ersten Isolationsstrukturen (104), die sich in das Substrat (101) erstrecken, geringer ist als eine Höhe eines Abschnitts jeder der Vielzahl von zweiten Isolationsstrukturen (105), die in dem Substrat (101) angeordnet sind,
ein Material der ersten dielektrischen Schicht vorzugsweise Siliziumoxid umfasst, und ein Material der zweiten dielektrischen Schicht gleich ist wie das Material der ersten dielektrischen Schicht, und wobei ein Material der dritten dielektrischen Schicht Siliziumnitrid umfasst und ein Material der vierten dielektrischen Schicht gleich ist wie das Material der dritten dielektrischen Schicht.

11. Struktur nach Anspruch 10, wobei das Substrat ein Siliziumsubstrat ist, die erste Halbleiterschicht eine Silizium-Germanium-Schicht ist und die zweite Halbleiterschicht eine Siliziumschicht ist,
die Gate-Struktur vorzugsweise eine Gate-Oxidschicht und ein leitendes Material auf einer Oberfläche der Gate-Oxidschicht umfasst.

12. Halbleiterstruktur nach einem der Ansprüche 10 bis 11, ferner umfassend:
eine fünfte dielektrische Schicht, die in der zweiten Halbleiterschicht angeordnet ist, wobei eine obere Fläche der fünften dielektrischen Schicht mit einer oberen Fläche der zweiten Halbleiterschicht bündig ist; und
einen Kontaktknoten und einen Kondensator, die auf der Source-Schicht angeordnet sind.

## Revendications

1. Procédé de formation d'une structure semi-conductrice, **caractérisée en ce que** le procédé comprend :
la fourniture (S101, S201, S301, S401) d'une base (100), dans lequel la base (100) comprend un substrat (101), une première couche semi-conductrice (102) et une seconde couche semi-conductrice (103) formées successivement l'une sur l'autre ;
la formation (S102) d'une pluralité de premières structures d'isolation (104) espacées les unes des autres et une pluralité de secondes structures d'isolation (105) espacées les unes des autres dans la base (100), comprend
la formation (S221, S402) d'une pluralité de tranchées de seconde structure d'isolation (105a) dans la base (100), et le remplissage de la pluralité de tranchées de seconde structure d'isolation (105a) avec une première couche diélectrique (105b) pour former une pluralité de secondes structures d'isolation initiales (105c) ; et
après la formation de la pluralité de secondes structures d'isolation initiales (105c) dans la base (100), la formation (S222) d'une pluralité de tranchées de première structure d'isolation (104a) dans la base (100), et le remplissage (S2221, S404) de la pluralité de tranchées de première structure d'isolation (104a) avec une deuxième couche diélectrique (104b) ;
le retrait (S2222, S405) de la deuxième couche diélectrique (104b) dans une partie inférieure de chacune de la pluralité de tranchées de première structure d'isolation (104a) et sur une surface de la seconde couche semi-conductrice (103) ; et
le remplissage (S2223, S407) de la pluralité de tranchées de première structure d'isolation (104a) avec une troisième couche diélectrique (104c) pour former une pluralité de premières structures d'isolation initiales (104d),
la gravure (S231, S408) de la deuxième couche diélectrique (104b) dans la pluralité de premières structures d'isolation initiales (104d) dans la seconde couche semi-conductrice (103), et la gravure de la première couche diélectrique (105b) dans la pluralité de secondes structures d'isolation initiales (105c) dans la seconde couche semi-conductrice (103) ;
le remplissage (S232, S409) de la pluralité de premières structures d'isolation initiales gravées (104d) dans la seconde couche semi-conductrice (103) avec une quatrième couche diélectrique (104e) ; et
la gravure (S233, S410) de la deuxième couche diélectrique (104b) dans la pluralité de premières structures d'isolation initiales (104d) dans la première couche semi-conductrice (102), et la gravure de la première couche diélectrique (105b) dans la pluralité de secondes structures d'isolation initiales (105c) dans la première couche semi-conductrice (102) pour former la pluralité de premières structures d'isolation (104) et la pluralité de secondes structures d'isolation (105),
dans lequel une couche de source (106) formée dans la seconde couche semi-conductrice (103) et une couche de drain (107) formée dans le substrat (101) sont prévues entre deux quelconques premières structures d'isolation (104) adjacentes de la pluralité de premières structures d'isolation (104), chacune de la pluralité de premières structures d'isolation (104) s'étend dans une première direction, chacune de la pluralité de secondes structures d'isolation (105) s'étend dans une seconde direction, la pluralité de premières structures d'isolation (104) pénètre à travers la première couche semi-conductrice (102) et la seconde couche semi-conductrice (103) et s'étend partiellement dans le substrat (101), et la pluralité de secondes structures d'isolation (105) est disposée dans le substrat (101) ;
la gravure (S234, S411) d'une partie de la première couche semi-conductrice (102) pour former (S103, S204, S304) une couche de canal (108) dans la première couche semi-conductrice (102), dans lequel un trou traversant (109) s'étendant dans la même direction que la première direction est prévu entre la couche de canal (108) et chacune de deux premières structures d'isolation (104) adjacentes à la couche de canal (108) ; et
la formation (S104, S205, S305) d'une structure de grille (110) dans le trou traversant (109).

2. Procédé selon la revendication 1, dans lequel le procédé, avant la formation (S102) de la pluralité de premières structures d'isolation (104) espacées les unes des autres et de la pluralité de secondes structures d'isolation (105) espacées les unes des autres dans la base (100), comprend en outre :
la réalisation (S302) d'un dopage ionique sur la seconde couche semi-conductrice (103) et une partie du substrat (101) pour former une zone dopée de drain dans le substrat (101), et pour former une zone dopée de source dans la seconde couche semi-conductrice (103).

3. Procédé selon la revendication 1, dans lequel chacune de la pluralité de premières structures d'isolation initiales (104d) s'étend dans la première direction, et chacune de la pluralité de secondes structures d'isolation initiales (105c) s'étend dans la seconde direction, et dans lequel la pluralité de premières structures d'isolation initiales (104d) et la pluralité de secondes structures d'isolation initiales (105c) pénètrent à travers la première couche semi-conductrice (102) et la seconde couche semi-conductrice (103), et s'étendent partiellement dans le substrat (101) pour former la couche de source (106) dans la seconde couche semi-conductrice (103) et pour former la couche de drain (107) dans le substrat (101).

4. Procédé selon la revendication 3, dans lequel la pluralité de tranchées de première structure d'isolation (104a) et la pluralité de tranchées de seconde structure d'isolation (105a) pénètrent à travers la première couche semi-conductrice (102) et la seconde couche semi-conductrice (103), et s'étendent partiellement dans le substrat (101).

5. Procédé selon la revendication4, dans lequel le procédé, après la gravure (S233, S410) de la deuxième couche diélectrique (104b) dans la pluralité de premières structures d'isolation initiales (104d) dans la première couche semi-conductrice (102) et la gravure de la première couche diélectrique (105b) dans la pluralité de secondes structures d'isolation initiales (105c) dans la première couche semi-conductrice (102), comprend :
la gravure (S234, S411) d'une partie de la première couche semi-conductrice (102) pour former la couche de canal (108), dans lequel le trou traversant (109) s'étendant dans la même direction que la première direction est prévu entre la couche de canal (108) et chacune des deux premières structures d'isolation (104) adjacentes à la couche de canal (108), et une largeur de la couche de canal (108) dans la seconde direction est inférieure à une largeur de la couche de source (106) et une largeur de la couche de drain (107) dans la seconde direction.

6. Procédé selon la revendication1, dans lequel le procédé, après le retrait (S2222, S405) de la deuxième couche diélectrique (104b) dans la partie inférieure de chacune de la pluralité de tranchées de première structure d'isolation (104a) et sur la surface de la seconde couche semi-conductrice (103), et avant de remplissage (S2223, S407) de la pluralité de tranchées de première structure d'isolation (104a) avec la troisième couche diélectrique (104c), comprend en outre :
le dépôt (S222a, S406) de cobalt métallique dans la partie inférieure de chacune de la pluralité de tranchées de première structure d'isolation (104a) ; et
la réalisation (S222b) d'un traitement de recuit pour former du siliciure dans le substrat (101) afin de former une ligne de bits enterrée (114), dans lequel la couche de drain (107) est disposée entre la couche de canal (108) et la ligne de bits enterrée (114), une hauteur d'une partie de chacune de la pluralité de premières structures d'isolation (104) s'étendant dans le substrat (101) est inférieure à une hauteur d'une partie de chacune de la pluralité de secondes structures d'isolation (105) disposées dans le substrat (101), et la pluralité de secondes structures d'isolation (105) pénètrent à travers la ligne de bits enterrée (114).

7. Procédé selon l'une quelconque des revendications 1 à6, dans lequel la formation (S104, S205, S305) de la structure de grille (110) dans le trou traversant (109) comprend :
la formation (S3051, S412) d'une couche d'oxyde de grille (110a) dans le trou traversant (109) par oxydation thermique ; et
le remplissage (S3052, S413) d'une surface de la couche d'oxyde de grille (110a) avec un matériau conducteur (110b) pour former la structure de grille (110).

8. Procédé selon la revendication7, comprenant en outre :
le remplissage (S306) de la seconde couche semi-conductrice (103) avec une cinquième couche diélectrique (111), dans lequel une surface supérieure de la cinquième couche diélectrique (111) est alignée avec une surface supérieure de la seconde couche semi-conductrice (103) ; et
la formation successive (S307) d'un noeud de contact (112) et d'un condensateur (113) sur la couche de source (106),
de préférence, un matériau de la couche d'oxyde de grille (110a) comprend de l'oxyde de silicium, et le matériau de la cinquième couche diélectrique (111) comprend du nitrure de silicium.

9. Procédé selon la revendication 6, dans lequel un matériau de la première couche diélectrique (105b) comprend de l'oxyde de silicium, et un matériau de la deuxième couche diélectrique (104b) est le même que le matériau de la première couche diélectrique (105b), et dans lequel un matériau de la troisième couche diélectrique (104c) comprend du nitrure de silicium, et un matériau de la quatrième couche diélectrique (104e) est le même que le matériau de la troisième couche diélectrique (104c).

10. Structure semi-conductrice, comprenant :
une base (100), dans laquelle la base (100) comprend un substrat (101), une première couche semi-conductrice (102) et une seconde couche semi-conductrice (103) formées successivement l'une sur l'autre ;
une pluralité de premières structures d'isolation (104) espacées les unes des autres et une pluralité de secondes structures d'isolation (105) espacées les unes des autres dans la base (100), dans lequel chacune de la pluralité de premières structures d'isolation (104) s'étend dans une première direction, chacune de la pluralité de secondes structures d'isolation (105) s'étend dans une seconde direction, la pluralité de premières structures d'isolation (104) pénètre à travers la première couche semi-conductrice (102) et la seconde couche semi-conductrice (103) et s'étend partiellement dans le substrat (101), et la pluralité de secondes structures d'isolation (105) est disposée dans le substrat (101) ;
une couche de source (106) disposée dans la seconde couche semi-conductrice (103) ;
une couche de drain (107) disposée dans le substrat (101) ;
une couche de canal (108) disposée dans la première couche semi-conductrice (102) ; et
une structure de grille (110) disposée entre la couche de canal (108) et chacune de deux premières structures d'isolation (104) adjacentes à la couche de canal (108) et s'étendant dans une même direction que la première direction, **caractérisée en ce que**, dans laquelle chacune de la pluralité de premières structures d'isolation (104) comprend : une deuxième couche diélectrique (104b) disposée dans le substrat (101), une quatrième couche diélectrique (104e) disposée dans la seconde couche semi-conductrice (103), et une troisième couche diélectrique (104c) pénétrant à travers la première couche semi-conductrice (102) et la seconde couche semi-conductrice (103) et s'étendant partiellement dans le substrat (101), et dans laquelle une paroi latérale de la troisième couche diélectrique (104c) est en contact avec chacune de la deuxième couche diélectrique (104b) et de la quatrième couche diélectrique (104e), dans laquelle la structure de grille (10) est en contact avec le deuxième couche diélectrique (104b), la quatrième
couche diélectrique (104e) et la paroi latérale de la
troisième couche diélectrique (104c), et la structure de grille (10) est située entre la deuxième couche diélectrique (104b) et la quatrième
couche diélectrique (104e), et chacune de la pluralité de secondes structures d'isolation (105) comprend une première couche diélectrique (105b) disposée dans le substrat (101),
de préférence, la structure semi-conductrice comprend en outre : une ligne de bits enterrée (114) disposée dans le substrat (101) et pénétrée par la pluralité de secondes structures d'isolation (105), dans laquelle la couche de drain (107) est disposée entre la couche de canal (108) et la ligne de bits enterrée (114), et une hauteur d'une partie de chacune de la pluralité de premières structures d'isolation (104) s'étendant dans le substrat (101) est inférieure à une hauteur d'une partie de chacune de la pluralité de secondes structures d'isolation (105) disposées dans le substrat (101),
de préférence, un matériau de la première couche diélectrique comprend de l'oxyde de silicium, et un matériau de la deuxième couche diélectrique est le même que le matériau de la première couche diélectrique, et dans laquelle un matériau de la troisième couche diélectrique comprend du nitrure de silicium, et un matériau de la quatrième couche diélectrique est le même que le matériau de la troisième couche diélectrique.

11. Structure selon la revendication 10, dans laquelle le substrat est un substrat de silicium, la première couche semi-conductrice est une couche de silicium-germanium et la seconde couche semi-conductrice est une couche de silicium,
de préférence, la structure de grille comprend une couche d'oxyde de grille et un matériau conducteur sur une surface de la couche d'oxyde de grille.

12. Structure semi-conductrice selon l'une quelconque des revendications 10 à 11, comprenant en outre :
une cinquième couche diélectrique disposée dans la seconde couche semi-conductrice, dans laquelle une surface supérieure de la cinquième couche diélectrique est alignée avec une surface supérieure de la seconde couche semi-conductrice ; et
un nœud de contact et un condensateur disposés sur la couche de source.
